# EUROPEAN PATENT APPLICATION

(11) **EP 4 704 537 A1**
(43) Date of publication of application: **04.03.2026**
(21) Application number: 25193146.5
(22) Date of filing: 31.07.2025
(51) Int. Cl.: H10K 59/131, H10K 59/129

(54) **DISPLAY DEVICE**

(30) Priority: 03.09.2024 KR 20240119175
(71) Applicant: LG Display Co., Ltd., Seoul, 07336 (KR)
(72) Inventor: CHOI, Hyeju, 10845 Paju-si (KR); SONG, Taejoon, 10845 Paju-si (KR)
(74) Representative: Beal, James Michael

(57) **Abstract**

A display device includes a substrate including a display area and a non-display area around the display area; a chip pad area disposed on the non-display area of the substrate, wherein a plurality of chip pads are disposed in the chip pad area and are arranged in a plurality of rows to constitute a plurality of pad rows; a driving circuit chip mounted on the chip pad area; and at least one pressure distribution structure vertically overlapping the driving circuit chip and disposed adjacent to each of the plurality of pad rows.

## Description

### BACKGROUND

### Field of Technology

The present disclosure relates to a display device.

### Description of Related Art

Display devices are applied to various electronic devices such as TV, mobile phones, laptops, and tablets.

For example, the display device includes an organic light-emitting display (OLED) that emits light by itself, and a liquid crystal display (LCD) that requires a separate light source, etc.

The display device includes a display panel including a plurality of sub-pixels and a driver for driving the display panel. The driver includes a scan driver for supplying a scan signal (or a gate signal) to the display panel, a data driver for supplying a data signal to the display panel, etc.

Recently, a technology for directly mounting a driving circuit chip on a flexible plastic substrate of a display panel, a so-called chip on plastic (COP) technology, has been used.

The description provided in the background section should not be assumed to be prior art merely because it is mentioned in or associated with the background section. The background section may include information that describes one or more aspects of the subject technology.

### SUMMARY

In the case of COP technology, an anisotropic conductive film is used to mount the driving circuit chip on the display panel. Pressure is applied to the flexible plastic substrate of the display panel in the process of mounting the driving circuit chip on a pad area of the display panel. Due to this pressure, the plastic substrate of the pad area of the display panel may be deformed. In this case, there is a possibility that cracks may occur in pads disposed in the pad area on which the driving circuit chip is mounted and lines around the pads. This may cause a defect in the electrical connection between the driving circuit chip and the display panel may occur.

A technical purpose of the present disclosure is to provide a display device in which pressure applied to chip pads of a display panel and lines around the chip pads may be distributed when a driving circuit chip is mounted on the display panel.

A technical purpose of the present disclosure is to provide a display device capable of efficiently absorbing an impact applied to chip pads of a display panel and lines around the chip pads when a driving circuit chip is mounted on the display panel.

A technical purpose of the present disclosure is to provide a display device capable of preventing cracks from occurring in chip pads of a display panel connected to a driving circuit chip and lines around the pads.

A technical purpose of the present disclosure is to provide a display device capable of reducing production energy and reducing greenhouse gas emission due to a reduction in a defect rate.

Purposes according to the present disclosure are not limited to the above-mentioned purpose. Other purposes and advantages according to the present disclosure that are not mentioned may be understood based on following descriptions, and may be more clearly understood based on embodiments according to the present disclosure. Further, it will be easily understood that the purposes and advantages according to the present disclosure may be realized using means shown in the claims or combinations thereof.

A display device according to an exemplary embodiment of the present disclosure includes: a substrate including a display area and a non-display area around the display area; a chip pad area disposed on the non-display area of the substrate, wherein a plurality of chip pads are disposed in the chip pad area and are arranged in a plurality of rows to constitute a plurality of pad rows; a driving circuit chip mounted on the chip pad area; and at least one pressure distribution structure vertically overlapping the driving circuit chip and disposed adjacent to at least one of the plurality of pad rows.

A display device according to an exemplary embodiment of the present disclosure includes: a substrate including a display area and a non-display area around the display area; a chip pad area disposed on the non-display area of the substrate and including a plurality of pads; a planarization layer covering edges of the plurality of pads and disposed on the substrate; a driving circuit chip mounted on the chip pad area via an anisotropic conductive film; and at least one pressure distribution structure disposed between the planarization layer and the driving circuit chip, wherein the at least one pressure distribution structure is disposed between bumps of the driving circuit chip, wherein an upper surface of the at least one pressure distribution structure is disposed closer to an upper surface of each of the bumps of the driving circuit chip than to a lower surface of each of the bumps of the driving circuit chip.

According to exemplary embodiments of the present disclosure, the pressure distribution structure is disposed around the chip pads of the display panel. Thus, when the driving circuit chip is mounted on the display panel, the driving circuit chip is supported by the pressure distribution structure. Thus, when the driving circuit chip is mounted thereon, a pressure applied to the chip pads of the display panel and lines around the chip pads can be distributed by the pressure distribution structure.

According to exemplary embodiments of the present disclosure, the pressure distribution structure is made of the organic insulating material, such that an impact applied to the chip pads of the display panel and the lines around the chip pads when the driving circuit chip is mounted thereon can be efficiently absorbed by the organic insulating material.

According to exemplary embodiments of the present disclosure, as the pressure applied to the chip pads of the display panel is distributed and the impact is absorbed by the pressure distribution structure, when the driving circuit chip is mounted on the display panel, cracks can be prevented from occurring in the chip pads of the display panel disposed under the driving circuit chip and lines around the chip pads.

According to the exemplary embodiments of the present disclosure, the pressure distribution structure includes the buffer portion and the enclosure portion surrounding the buffer portion. Thus, a height of the pressure distribution structure may be easily adjusted by adjusting a height of the buffer portion. Therefore, in the mounting process of the driving circuit chip, the pressure distribution structure can be formed to have the height similar to that of each of the bumps of the driving circuit chip so that the pressure distribution structure can reliably support the lower surface of the driving circuit chip.

According to exemplary embodiments of the present disclosure, the pressure distribution structure is adhered to the driving circuit chip via an anisotropic conductive film including conductive particles, and a lower surface of the driving circuit chip is in contact with either the pressure distribution structure or one or more of the conductive particles of the anisotropic conductive film in response to pressure applied to the substrate or the driving circuit chip toward each other.

According to exemplary embodiments of the present disclosure, the defect rate of the display device due to the defect including cracks occurring in the chip pads of the display panel is lowered, so that production energy required for production of the display device can be reduced and greenhouse gas emission for the production thereof may be reduced.

Effects of the present disclosure are not limited to the effects mentioned above, and other effects not mentioned will be clearly understood by those skilled in the art from the description as set forth below.

In addition to the above effects, specific effects of the present disclosure are described together while describing specific details for carrying out the present disclosure.

It is to be understood that both the foregoing general description and the following detailed description are exemplary and explanatory and are intended to provide further explanation of the inventive concepts as claimed.

### BRIEF DESCRIPTION OF DRAWINGS

The accompanying drawings, which are included to provide a further understanding of the disclosure and are incorporated in and constitute a part of this application, illustrate embodiments of the disclosure and together with the description serve to explain the principle of the disclosure. In the drawings:
FIG. 1 is an exploded perspective view of a display device according to an exemplary embodiment of the present disclosure.
FIG. 2 is a plan view of a display panel according to an exemplary embodiment of the present disclosure.
FIG. 3 is a plan view illustrating a chip pad area according to an exemplary embodiment of the present disclosure.
FIG. 4 is a cross-sectional view illustrating a display device taken along a line I-I' of FIG. 2.
FIG. 5 is a cross-sectional view illustrating a display device taken along a line II-II' of FIG. 3.
FIG. 6 is a cross-sectional view illustrating a display device taken along a line III-III' of FIG. 3.
FIGS. 7 to 10 are cross-sectional views illustrating a method for manufacturing a pressure distribution structure according to an exemplary embodiment of the present disclosure.
FIGS. 11 to 14 are plan views illustrating pressure distribution structures according to exemplary embodiments of the present disclosure.

Throughout the drawings and the detailed description, unless otherwise described, the same drawing reference numerals should be understood to refer to the same elements, features, and structures. The relative size and depiction of these elements may be exaggerated for clarity, illustration, and convenience.

### DETAILED DESCRIPTIONS

Reference will now be made in detail to embodiments of the present disclosure, examples of which may be illustrated in the accompanying drawings. The progression of processing steps and/or operations described is an example; however, the sequence of steps and/or operations is not limited to that set forth herein and may be changed as is known in the art, with the exception of steps and/or operations necessarily occurring in a particular order. Names of the respective elements used in the following explanations may be selected only for convenience of writing the specification and may be thus different from those used in actual products.

Advantages and features of the present disclosure, and a method of achieving the advantages and features will become apparent with reference to embodiments described below in detail together with the accompanying drawings. However, the present disclosure is not limited to the embodiments as disclosed under, but may be implemented in various different forms. Thus, these embodiments are set forth only to make the present disclosure complete, and to entirely inform the scope of the present disclosure to those of ordinary skill in the technical field to which the present disclosure belongs.

For simplicity and clarity of illustration, elements in the drawings are not necessarily drawn to scale. The same reference numbers in different drawings represent the same or similar elements, and as such perform similar functionality. Further, descriptions and details of well-known steps and elements are omitted for simplicity of the description. Furthermore, in the following detailed description of the present disclosure, numerous specific details are set forth in order to provide a thorough understanding of the present disclosure. However, it will be understood that the present disclosure may be practiced without these specific details. In other instances, well-known methods, procedures, components, and circuits have not been described in detail so as not to unnecessarily obscure aspects of the present disclosure. Examples of various embodiments are illustrated and described further below. It will be understood that the description herein is not intended to limit the claims to the specific embodiments described. On the contrary, it is intended to cover alternatives, modifications, and equivalents as may be included within the spirit and scope of the present disclosure as defined by the appended claims.

A shape (e.g., sizes, lengths, widths, heights, thicknesses, locations, radii, diameters, and areas), a ratio, an angle, a number, etc. disclosed in the drawings for illustrating embodiments of the present disclosure are illustrative, and the present disclosure is not limited thereto. The terminology used herein is directed to the purpose of describing particular embodiments only and is not intended to be limiting of the present disclosure. As used herein, the singular constitutes "a" and "an" are intended to include the plural constitutes as well, unless the context clearly indicates otherwise. It will be further understood that the terms "comprise", "comprising", "include", and "including" when used in this disclosure, specify the presence of the stated features, integers, operations, elements, and/or components, but do not preclude the presence or addition of one or more other features, integers, operations, elements, components, and/or portions thereof. As used herein, the term "and/or" includes any and all combinations of one or more of associated listed items. Expression such as "at least one of" when preceding a list of elements may modify an entirety of the list of elements and may not modify the individual elements of the list.

In interpretation of numerical values, an error or tolerance therein may occur even when there is no explicit description thereof.

In addition, it will also be understood that when a first element or layer is referred to as being present "on" a second element or layer, the first element may be disposed directly on the second element or may be disposed indirectly on the second element with a third element or layer being disposed between the first and second elements or layers. It will be understood that when a first element or layer is referred to as being "connected to", or "coupled to" a second element or layer, the first element may be directly connected to or coupled to the second element or layer, or one or more intervening elements or layers may be present therebetween. In addition, it will also be understood that when an element or layer is referred to as being "between" two elements or layers, it may be the only element or layer between the two elements or layers, or one or more intervening elements or layers may also be present therebetween.

Further, as used herein, when a layer, film, area, plate, or the like is disposed "on" or "on a top" of another layer, film, area, plate, or the like, the former may directly contact the latter or still another layer, film, area, plate, or the like may be disposed between the former and the latter. As used herein, when a layer, film, area, plate, or the like is directly disposed "on" or "on a top" of another layer, film, area, plate, or the like, the former directly contacts the latter and still another layer, film, area, plate, or the like is not disposed between the former and the latter. Further, as used herein, when a layer, film, area, plate, or the like is disposed "below" or "under" another layer, film, area, plate, or the like, the former may directly contact the latter or still another layer, film, area, plate, or the like may be disposed between the former and the latter. As used herein, when a layer, film, area, plate, or the like is directly disposed "below" or "under" another layer, film, area, plate, or the like, the former directly contacts the latter and still another layer, film, area, plate, or the like is not disposed between the former and the latter.

In descriptions of temporal relationships, for example, temporal precedent relationships between two events such as "after", "subsequent to", "before", etc., another event may occur therebetween unless "directly after", "directly subsequent" or "directly before" is indicated. When a certain embodiment may be implemented differently, a function or an operation specified in a specific block may occur in a different order from an order specified in a flowchart. For example, two blocks in succession may be actually performed substantially concurrently, or the two blocks may be performed in a reverse order depending on a function or operation involved.

It will be understood that, although the terms "first", "second", "third", "A," "B," "(a)," and "(b)," and so on may be used herein to describe various elements, components, areas, layers and/or periods, these elements, components, areas, layers and/or periods should not be limited by these terms. These terms are used to distinguish one element, component, area, layer or section from another element, component, area, layer or section. Thus, a first element, component, area, layer or section as described under could be termed a second element, component, area, layer or section, without departing from the spirit and scope of the present disclosure.

When an embodiment may be implemented differently, functions or operations specified within a specific block may be performed in a different order from an order specified in a flowchart. For example, two consecutive blocks may actually be performed substantially simultaneously, or the blocks may be performed in a reverse order depending on related functions or operations.

The features of the various embodiments of the present disclosure may be partially or entirely combined with each other, and may be technically associated with each other or operate with each other. The embodiments may be implemented independently of each other and may be implemented together in an association relationship.

In interpreting a numerical value, the value is interpreted as including an error range unless there is separate explicit description thereof. Unless otherwise defined, all terms including technical and scientific terms used herein have the same meaning as commonly understood by one of ordinary skill in the art to which this inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, "embodiments," "examples," "aspects, etc. should not be construed such that any aspect or design as described is superior to or advantageous over other aspects or designs. Further, the term 'or' means 'inclusive or' rather than 'exclusive or'. That is, unless otherwise stated or clear from the context, the expression that 'x uses a or b' means one of natural inclusive permutations.

The terms used in the description as set forth below have been selected as being general and universal in the related technical field. However, there may be other terms than the terms depending on the development and/or change of technology, convention, preference of technicians, etc. Therefore, the terms used in the description as set forth below should not be understood as limiting technical ideas, but should be understood as examples of the terms for illustrating embodiments. Further, in a specific case, a term may be arbitrarily selected by the applicant, and in this case, the detailed meaning thereof will be described in a corresponding description period. Therefore, the terms used in the description as set forth below should be understood based on not simply the name of the terms, but the meaning of the terms and the contents throughout the Detailed Descriptions.

In description of flow of a signal, for example, when a signal is delivered from a node A to a node B, this may include a case where the signal is transferred from the node A to the node B via another node unless a phrase 'immediately transferred' or 'directly transferred' is used. Throughout the present disclosure, "A and/or B" means A, B, or A and B, unless otherwise specified, and "C to D" means C inclusive to D inclusive unless otherwise specified.

As used herein, a first direction, a second direction, and a third direction, or an X-axis direction, a Y-axis direction, and a Z-axis direction should not be interpreted only as having a geometric relationship with each other in which the first direction, the second direction, and the third direction are perpendicular to each other or the X-axis direction, the Y-axis direction, and the Z-axis direction are perpendicular to each other, but may be interpreted as having a geometric relationship with each other in which the first direction, the second direction, and the third direction interest each other at an angle other than 90 degrees or the X-axis direction, the Y-axis direction, and the Z-axis direction are interest each other at an angle other than 90 degrees within a range in which a configuration of the present disclosure may work functionally.

When a first component or layer is described as "contacting" or "overlapping" a second component or layer, it should be understood that the first component or layer may directly contact or overlap the second component or layer, or a third component or layer may be interposed between the first and second components or layers that may indirectly contact or overlap each other unless otherwise specified.

Hereinafter, various exemplary embodiments of the present disclosure will be described in detail with reference to the accompanying drawings.

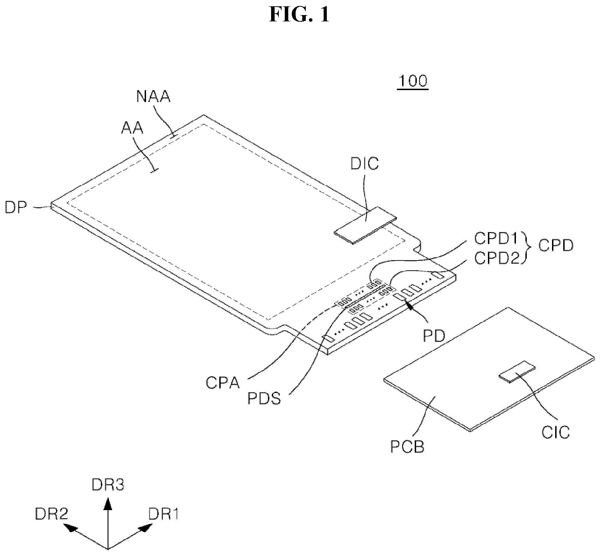

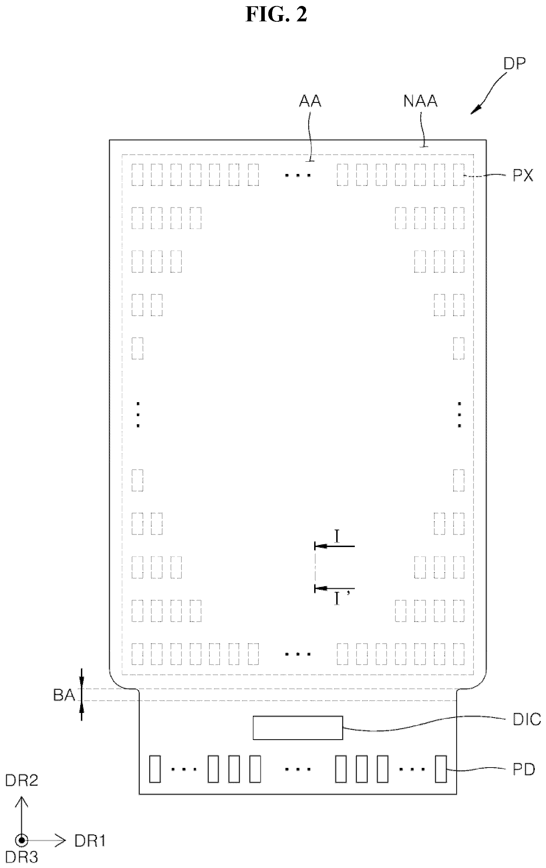

FIG. 1 is an exploded perspective view of a display device according to an exemplary embodiment of the present disclosure. FIG. 2 is a plan view of a display panel according to an exemplary embodiment of the present disclosure.

Referring to FIGS. 1 and 2, as an example, a display device 100 may include a display panel DP, a driving circuit chip DIC, a printed circuit board PCB, and a control circuit chip CIC, without being limited thereto.

The display panel DP may include a plurality of pixels PX, a plurality of chip pads CPD, and a plurality of pads PD. The plurality of pixels PX may be disposed in a display area AA of the display panel DP, and the plurality of chip pads CPD and the plurality of pads PD may be disposed in the non-display area NAA, without being limited thereto.

A shape of the display area AA illustrated in FIGS. 1 and 2 is merely an example, and the shape of the display area AA may vary without limitation thereto as needed. The non-display area NAA is an area which is disposed around the display area AA and in which no image is displayed. A bezel area of the display device 100 may be defined by the non-display area NAA. The non-display area NAA may fully or partially surround the display area AA. As an example, the display area AA may have a rectangular shape, a square shape, a circular shape, an oval shape, a triangle shape, a polygonal shape, etc. As an example, the non-display area NAA may be extended from the display area AA. As an example, at least a portion of or the entirety of the non-display area NAA may be invisible from a front side (viewing side) of the display panel DP, for example, by being bent toward a rear side of the display panel DP, without being limited thereto.

Lines for providing an electrical signal to the display area AA or receiving an electrical signal from the display area AA may be disposed in the non-display area NAA. A gate driver (not shown) for supplying a gate signal to the plurality of pixels PX of the display area AA may be disposed in the non-display area NAA. The gate driver may be disposed at one side or each of both opposing sides of the non-display area NAA of the display panel DP in a gate in panel (GIP) manner. As an example, the gate driver may be not disposed in the non-display area NAA. As an example, the gate driver may be separately disposed in a separate panel and connected to the display panel DP, for example, in a tape automated bonding (TAB) method, a chip on glass (COG) method, a chip on panel (COP) method, or a chip on film (COF) method, without being limited thereto.

The non-display area NAA includes a chip pad area CPA in which a plurality of chip pads CPD are disposed. A driving circuit chip DIC may be mounted on the chip pad area CPA. The driving circuit chip DIC may be disposed to overlap the plurality of chip pads CPD. The plurality of chip pads CPD may include a plurality of output pads CPD1 and a plurality of input pads CPD2. The output bumps of the driving circuit chip DIC may be electrically connected to the output pads CPD1 of the display panel DP via an anisotropic conductive film, and the input bumps of the driving circuit chip DIC may be electrically connected to the input pads CPD2 of the display panel DP via an anisotropic conductive film.

The plurality of chip pads CPD may be electrically connected to the plurality of pixels PX via a plurality of data lines. The driving circuit chip DIC may transmit a data signal to the plurality of pixels PX of the display area AA via the plurality of chip pads CPD and the plurality of data lines. The driving circuit chip DIC may be a data driving circuit chip.

A pressure distribution structure PDS as well as the plurality of chip pads CPD may be disposed in the chip pad area CPA. The pressure distribution structure PDS may be disposed around the plurality of chip pads CPD. The pressure distribution structure PDS may be disposed in various areas of the chip pad area CPA including an area between each of the output pads CPD1 and each of the input pads CPD2. The pressure distribution structure PDS may distribute pressure applied to the plurality of chip pads CPD when the driving circuit chip DIC is mounted on the chip pad area CPA. Accordingly, in the process of bonding the driving circuit chip DIC to the chip pad area CPA of the display panel DP, cracks may be reduced or prevented from occurring in the plurality of chip pads CPD or a pad connection line.

The printed circuit board PCB may be electrically connected to the plurality of pads PD, for example, via an anisotropic conductive film. The control circuit chip CIC may be mounted on the printed circuit board PCB. The printed circuit board PCB may be a flexible printed circuit board, without being limited thereto.

The control circuit chip CIC may control the driving circuit chip DIC and the gate driver (not shown).

A bendable area BA of the display panel DP may be bent so that the printed circuit board PCB and the driving circuit chip DIC may be disposed under the display area AA of the display panel DP. Accordingly, the non-display area NAA of the display device 100 may be reduced.

The bendable area BA may be an area located between the display panel DP and the driving circuit chip DIC. For example, the bendable area BA may be a portion of an area of the non-display area NAA of the display panel DP on which the driving circuit chip DIC is not mounted. Embodiments are not limited thereto. As an example, the bendable area BA may be omitted, or two or more bendable areas BA may be provided, depending on the design.

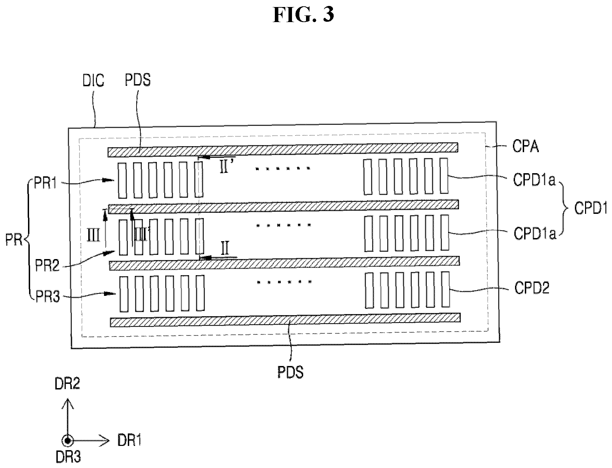

FIG. 3 is a plan view illustrating a chip pad area according to an exemplary embodiment of the present disclosure.

Referring to FIG. 3, the plurality of chip pads CPD may be disposed in the chip pad area CPA of the display panel DP and may be arranged in a plurality of rows to constitute a plurality of pad rows PR. The plurality of output pads CPD1 and the plurality of input pads CPD2 may be disposed in the chip pad area CPA. For example, the plurality of output pads CPD1 may include a plurality of first output pads CPD1a and a plurality of second output pads CPD1b. For example, the plurality of first output pads CPD1a may be arranged in a first direction DR1 to constitute a first pad row PR1. For example, the plurality of second output pads CPD1b may be arranged in the first direction DR1 to constitute a second pad row PR2. For example, the plurality of input pads CPD2 may be arranged in the first direction DR1 to constitute a third pad row PR3. In another exemplary embodiment, the plurality of output pads CPD1 may be arranged in one row or in three or more rows. In another exemplary embodiment, the plurality of input pads CPD2 may be arranged in two or more rows. The first to third pad rows PR1, PR2, PR3 may be spaced apart from each other in a second direction DR2 intersecting the first direction DR1. The first direction DR1 may be a row direction, and the second direction DR2 may be a column direction. As an example, the second direction DR2 may be a direction in which the chip pad area CPA extends from the display area AA, and the first direction DR1 may be a direction in parallel with a side of the display area AA from which the chip pad area CPA extends, without being limited thereto. As an example, the second direction DR2 may be perpendicular to the first direction DR1, without being limited thereto. The chip pad area CPA is located spaced apart from one side of the display area AA in the second direction DR2 perpendicular to the first direction DR1.

At least one pressure distribution structure PDS may be disposed in the chip pad area CPA of the display panel DP. All or at least one of the at least one pressure distribution structure PDS may partially or entirely overlap the driving circuit chip DIC and may be disposed adjacent to the plurality of pad rows PR. As used herein, references to the pressure distribution structure PDS vertically overlapping the driving circuit chip DIC may indicate that the pressure distribution structure PDS overlaps the driving circuit chip DIC in a cross sectional view of the display device, i.e. along the third direction DR3. As used herein, references to the pressure distribution structure PDS being disposed adjacent to chip pads CPD may indicate that the pressure distribution structure PDS is disposed next to the chip pads CPD in a plan view of the display device, e.g. along the second direction DR2. A plurality of pressure distribution structures PDS may be disposed around the plurality of pad rows PR. In the present exemplary embodiment, each of a plurality of pressure distribution structures PDS may be disposed on upper and lower sides of each of the plurality of pad rows PR in a plan view of the display panel. The upper and lower sides of each of the plurality of pad rows PR may be opposite sides in the second direction DR2 of each of the plurality of pad rows PR. Each of the plurality of pressure distribution structures PDS may be disposed in an area between adjacent ones of the plurality of pad rows PR, and disposed on an upper side of the first pad row PR1 and a lower side of the third pad row PR3 in a plan view of the display panel. In an exemplary embodiment, each of the plurality of pressure distribution structures PDS may be disposed only in an area between adjacent ones of the plurality of pad rows PR. In an exemplary embodiment, two pressure distribution structures PDS may be respectively disposed only on the upper side of the first pad row PR1 and on the lower side of the third pad row PR3 in a plan view of the display panel. Each of the pad rows PR1, PR2, and PR3 includes the plurality of chip pads CPD arranged in the first direction DR1. The first pad row PR1 includes the plurality of first output pads CPD1a arranged in the first direction DR1. The second pad row PR1 includes the plurality of second output pads CPD1b arranged in the first direction DR1. The third pad row PR3 includes the plurality of input pads CPD2 arranged in the first direction DR1.

As an example, each of the pressure distribution structures PDS may have a linear shape extending in the first direction DR 1, without being limited thereto. In this regard, the linear shape includes both a straight linear shape and a curved linear shape. The shape of the pressure distribution structure PDS may also vary depending on a shape in which the plurality of chip pads CPD are arranged. As illustrated in FIG. 3, when the plurality of chip pads CPD are arranged along a plurality of straight row lines to constitute the plurality of rows, each of the plurality of pressure distribution structures PDS may extend in a straight linear shape. In an exemplary embodiment, when the plurality of chip pads CPD are arranged along a plurality of curved row lines to constitute a plurality of rows, each of the plurality of pressure distribution structures PDS may extend in a curved linear shape. Each pressure distribution structure PDS may continuously extend in the chip pad area CPA from a left side to a right side of the chip pad area CPA. The plurality of pressure distribution structures PDS may be spaced from each other in the second direction DR2 intersecting the first direction DR1.

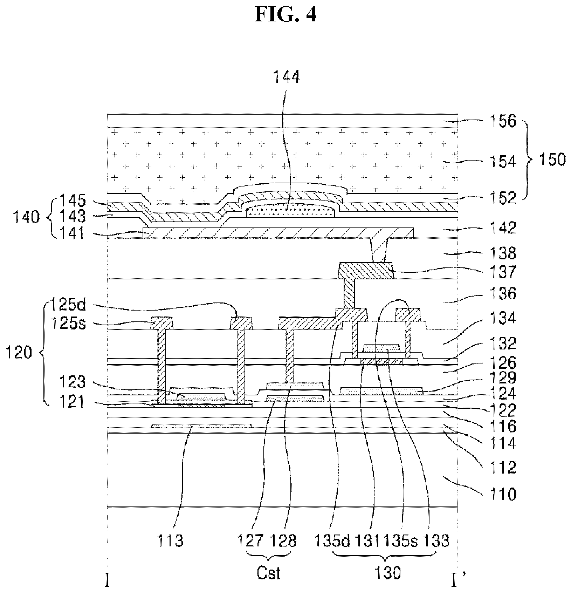

FIG. 4 is a cross-sectional view illustrating a display device taken along a line I-I' of FIG. 2. FIG. 4 schematically illustrates a sub-pixel of a display device.

Referring to FIG. 4, the display device may include a substrate 110, and a plurality of thin-film transistors 120 and 130, a capacitor Cst, and a light-emitting element 140 disposed on the substrate 110. The plurality of thin-film transistors 120 and 130 may include a first thin-film transistor 120 and a second thin-film transistor 130. As an example, the first thin-film transistor 120 and the second thin-film transistor 130 may include the same semiconductor materials or different materials such as a polycrystalline semiconductor material, an oxide semiconductor material, a monocrystalline semiconductor material, an amorphous semiconductor material, a compound semiconductor material or an organic semiconductor material, etc. As an example, the first thin-film transistor may include a polycrystalline semiconductor material and the second thin-film transistor 130 may include an oxide semiconductor material, without being limited thereto.

One sub-pixel includes the light-emitting element 140 and a pixel driving circuit for applying a driving current to the light-emitting element 140. The pixel driving circuit is disposed on the substrate 110, and the light-emitting element 140 is disposed on the pixel driving circuit. The pixel driving circuit may include a driving thin-film transistor, one or more switching thin-film transistors, and a capacitor. The first and second thin-film transistors 120 and 130 may be the driving thin-film transistor and/or the switching thin-film transistors. Embodiments are not limited thereto. As an example, one or more thin-film transistors or one or more capacitors may be further included.

The substrate 110 may be a flexible substrate or a rigid substrate. As an example, the substrate 110 may be a flexible plastic substrate, and may be made of, for example, an organic insulating material such as polyimide. The substrate 110 may be implemented as, for example, a single layer or a multi-layer stack in which organic insulating material layers and inorganic insulating material layers are alternately stacked on top of each other. For example, the substrate 110 may be formed by alternately stacking the organic insulating material layers made of, for example, polyimide and the inorganic insulating material layers made of, for example, silicon oxide (SiOx). For example, the substrate 110 may have a three-layer structure in which a silicon oxide layer is disposed between two polyimide layers.

A first lower buffer layer 112 and a second lower buffer layer 114 are formed on the substrate 110. Each of the first and second lower buffer layers 112 and 114 may be embodied as a single layer or a multilayer stack made of an inorganic insulating material such as silicon oxide (SiOx), silicon nitride (SiNx), or the like to block moisture or oxygen that may be introduced from the outside in a permeating manner. As an example, a first light-shielding layer 113 may be disposed between the first lower buffer layer 112 and the second lower buffer layer 114, without being limited thereto.

An auxiliary buffer layer 116 may be further disposed on the second lower buffer layer 114 to block moisture or oxygen that may be introduced from the outside in a permeating manner. The auxiliary buffer layer 116 may be embodied as a single layer or a multilayer stack made of an inorganic insulating material such as silicon oxide (SiOx) or silicon nitride (SiNx).

The first thin-film transistor 120 may be disposed on the auxiliary buffer layer 116. The first thin-film transistor 120 includes a first active layer 121 made of a polycrystalline semiconductor material, a first gate electrode 123 overlapping a channel area of the first active layer 121, a first source electrode 125s connected to a source area of the first active layer 121, and a first drain electrode 125d connected to a drain area of the first active layer 121.

The first active layer 121 may be disposed on the auxiliary buffer layer 116. A first gate insulating layer 122 is disposed between the first gate electrode 123 and the first active layer 121. The first gate insulating layer 122 may cover the first active layer 121 and may be disposed on the auxiliary buffer layer 116. The first gate insulating layer 122 may be embodied as a single layer or a stack of multiple layers made of an inorganic insulating material such as silicon oxide (SiOx) or silicon nitride (SiNx).

Between the first lower buffer layer 112 and the second lower buffer layer 114, a first light-shielding layer 113 is disposed to overlap the first active layer 121, and reduces or prevents light from being incident on the first active layer 121, thereby securing reliability of the first thin-film transistor 120. As an example, the first light-shielding layer 113 may be made of a metal material, without being limited thereto. As an example, the first light-shielding layer 113 may be electrically connected to the first gate electrode 123 to form a dual gate, or may be floated. For example, the first light-shielding layer 113 may be embodied as a single layer or a stack of multiple layers made of one of molybdenum (Mo), aluminum (Al), chromium (Cr), gold (Au), titanium (Ti), nickel (Ni), neodymium (Nd), and copper (Cu) or an alloy thereof. However, embodiments of the present disclosure are not limited thereto. As an example, the first light-shielding layer 113 may be omitted depending on the design.

The capacitor Cst includes a first electrode 127 and a second electrode 128. The first electrode 127 may be disposed on the first gate insulating layer 122. As an example, the first electrode 127 may be made of the same material as that of the first gate electrode 123 of the first thin-film transistor 120. As an example, the first gate electrode 123 and the first electrode 127 are made of a metal material. For example, the first gate electrode 123 and the first electrode 127 may be embodied as a single layer or a stack of multiple layers made of one of molybdenum (Mo), aluminum (Al), chromium (Cr), gold (Au), titanium (Ti), nickel (Ni), neodymium (Nd), and copper (Cu), or an alloy thereof. However, embodiments of the present disclosure are not limited thereto. As an example, the first electrode 127 may be disposed on a different layer from the first gate electrode 123, or may be made of a different material from that of the first gate electrode 123.

The first interlayer insulating layer 124 may be disposed on the first gate electrode 123 and the first electrode 127. The first interlayer insulating layer 124 may be embodied as a single layer or a stack of multiple layers made of an inorganic insulating material such as silicon oxide (SiOx) or silicon nitride (SiNx).

As an example, the second electrode 128 of the capacitor Cst and the second light-shielding layer 129 may be disposed on the first interlayer insulating layer 124. The second electrode 128 may be made of the same material as that of the second light-shielding layer 129. The second electrode 128 and the second light-shielding layer 129 are made of a metal material. For example, each of the second electrode 128 and the second light-shielding layer 129 may be embodied as a single layer or a stack of multiple layers made of one of molybdenum (Mo), aluminum (Al), chromium (Cr), gold (Au), titanium (Ti), nickel (Ni), neodymium (Nd), and copper (Cu), or an alloy thereof. However, embodiments of the present disclosure are not limited thereto. As an example, the second electrode 128 of the capacitor Cst and the second light-shielding layer 129 may be disposed on different layers, or may be made of different materials. As an example, the second light-shielding layer 129 may be omitted depending on the design.

An upper buffer layer 126 may be disposed on the second electrode 128 and the second light-shielding layer 129. The second thin-film transistor 130 may be disposed on the upper buffer layer 126. The second thin-film transistor 130 includes a second active layer 131 made of an oxide semiconductor material, a second gate electrode 133 overlapping a channel area of the second active layer 131, a second source electrode 135s connected to a source area of the second active layer 131, and a second drain electrode 135d connected to a drain area of the second active layer 131. The upper buffer layer 126 spaces the second active layer 131 made of an oxide semiconductor material from the first active layer 121 made of a polycrystalline semiconductor material, and provides a basis for forming the second active layer 131. The upper buffer layer 126 may be embodied as a single layer or a multilayer stack made of an inorganic insulating material such as silicon oxide (SiOx) or silicon nitride (SiNx).

The second active layer 131 may be disposed on the upper buffer layer 126. A second gate insulating layer 132 is disposed between the second gate electrode 133 and the second active layer 131. The second gate insulating layer 132 may cover the second active layer 131 and may be disposed on the upper buffer layer 126. The second gate insulating layer 132 may be embodied as a single layer or a stack of multiple layers made of an inorganic insulating material such as silicon oxide (SiOx) or silicon nitride (SiNx).

The second gate electrode 133 may be made of a metal material. For example, the second gate electrode 133 may be embodied as a single layer or a stack of multiple layers made of one of molybdenum (Mo), aluminum (Al), chromium (Cr), gold (Au), titanium (Ti), nickel (Ni), neodymium (Nd), and copper (Cu) or an alloy thereof. However, embodiments of the present disclosure are not limited thereto.

A second light-shielding layer 129 may be disposed to overlap the second active layer 131, and may reduce or prevent light from being incident on the second active layer 131, thereby securing reliability of the second thin-film transistor 130. As an example, the second light-shielding layer 129 may be electrically connected to the second gate electrode 133 to form a dual gate, or may be floated, without being limited thereto. As an example, the second light-shielding layer 129 may be omitted depending on the design.

A second interlayer insulating layer 134 covering the second gate electrode 133 may be disposed on the second gate insulating layer 132.

A first source electrode 125s, a first drain electrode 125d, a second source electrode 135s, and a second drain electrode 135d may be disposed on the second interlayer insulating layer 134. As an example, the first source electrode 125s, the first drain electrode 125d, the second source electrode 135s, and the second drain electrode 135d may be simultaneously formed on the second interlayer insulating layer 134 and may be made of the same material, without being limited thereto. The first source electrode 125s and the first drain electrode 125d may be respectively connected to a source area and a drain area of the first active layer 121 respectively via two corresponding through-holes extending through the second interlayer insulating layer 134, the second gate insulating layer 132, the upper buffer layer 126, the first interlayer insulating layer 124, and the first gate insulating layer 122. The second source electrode 135s and the second drain electrode 135d may be connected to a source area and a drain area of the second active layer 131, respectively via two corresponding through-holes extending through the second interlayer insulating layer 134 and the second gate insulating layer 132.

The second drain electrode 135d or the second source electrode 135s of the second thin-film transistor 130 may be electrically connected to the second electrode 128 of the capacitor Cst via a through-hole extending through the second interlayer insulating layer 134, the second gate insulating layer 132, and the upper buffer layer 126. However, the present disclosure is not limited thereto, and a connection relationship of the capacitor Cst may vary depending on a structure of the pixel driving circuit.

In one example, a first planarization layer 136 and a second planarization layer 138 are sequentially disposed on the pixel driving circuit to planarize a step due to the pixel driving circuit. The first planarization layer 136 and the second planarization layer 138 may be made of an organic insulating material such as polyimide or acrylic resin.

In addition, the light-emitting element 140 may be formed on the second planarization layer 138.

The light-emitting element 140 includes an anode electrode 141, a cathode electrode 145, and a light-emitting layer 143 disposed between the anode electrode 141 and the cathode electrode 145.

The light-emitting element 140 is electrically connected to the pixel driving circuit via an intermediate electrode 137 disposed on the first planarization layer 136, or may be directly connected to the pixel driving circuit without the intermediate electrode 137, which thereby could be omitted. For example, the anode electrode 141 of the light-emitting element 140 may be connected to the first drain electrode 135d of the second thin-film transistor 130 via the intermediate electrode 137.

The anode electrode 141 may be connected to the intermediate electrode 137 via a contact hole extending through the second planarization layer 138. In addition, the intermediate electrode 137 may be connected to the second drain electrode 135d via a contact hole extending through the first planarization layer 136.

The intermediate electrode 137 may be embodied as a single layer or a stack of multiple layers made of one of molybdenum (Mo), aluminum (Al), chromium (Cr), gold (Au), titanium (Ti), nickel (Ni), neodymium (Nd), and copper (Cu) or an alloy thereof. However, embodiments of the present disclosure are not limited thereto.

The anode electrode 141 may be formed of a conductive material. As an example, the anode electrode 141 may be formed in a multilayer structure including a transparent conductive film and an opaque conductive film having high reflection efficiency, without being limited thereto. The transparent conductive film may be made of a material having a relatively high work function value, such as indium-tin-oxide (ITO) or indium-zinc-oxide (IZO), and the opaque conductive film may be made of a single layer or multi-layer structure including aluminum (Al), silver (Ag), copper (Cu), lead (Pb), molybdenum (Mo), titanium (Ti), or an alloy thereof. For example, the anode electrode 141 may be formed in a structure in which a transparent conductive film, an opaque conductive film, and a transparent conductive film are sequentially stacked, or may be formed in a structure in which a transparent conductive film and an opaque conductive film are sequentially stacked, without being limited thereto.

The light-emitting layer 143 may include a hole injection layer, a hole transport layer, an organic light-emitting layer, an electron transport layer, and an electron injection layer sequentially stacked on the anode electrode 141. Embodiments are not limited thereto. As an example, at least one or all of the hole injection layer, the hole transport layer, the electron transport layer, and the electron injection layer may be omitted, depending on the design.

A bank layer 142 may act as a pixel defining layer that exposes a partial area (e.g., a central area) of each anode electrode 141. The bank layer 142 may be made of an organic insulating material. The bank layer 142 may include, for example, one of photosensitive polyimide, photoacryl, and benzocyclobutene (BCB), without being limited thereto. The bank layer 142 may be made of an opaque material to reduce or prevent optical interference between adjacent pixels. In this case, the bank layer 142 includes a light-shielding material made of at least one of a color pigment, organic black, and carbon, without being limited thereto.

A spacer 144 may be further disposed on the bank layer 142. A fine metal mask as a deposition mask may be used to form the light-emitting layer 143. In order to reduce or prevent damage to the bank layer 142 and the anode electrode 141 that may occur due to contact between the deposition mask and the bank layer by maintaining a predetermined distance between the bank layer 142 and the deposition mask, the spacer 144 may be disposed on the bank layer 142. As an example, the spacer 144 may be omitted depending on the design.

As an example, the spacer 144 may be made of the same material as that of the bank layer 142. As an example, the bank layer 142 and the spacer 144 may be formed simultaneously in a single process. However, embodiments of the present disclosure are not limited thereto. The spacer 144 may be made of a material different from that of the bank layer 142, and the bank layer 142 and the spacer 144 may be formed in separate processes. The spacer 144 may be made of an organic insulating material, without being limited thereto. The spacer 144 may include one of photosensitive polyimide, photoacryl, and benzocyclobutene (BCB) , without being limited thereto.

The cathode electrode 145 may be integrally formed in a monolithic manner across an entirety of the display area AA, or may be individually formed in each pixel. In a top emission type organic light-emitting display device, the cathode electrode 145 may be made of a transparent conductive film such as indium-tin-oxide (ITO) or indium-zinc-oxide (IZO), without being limited thereto.

An encapsulation layer 150 for suppressing moisture penetration may be further disposed on the cathode electrode 145. The encapsulation layer 150 may include inorganic or organic materials. As an example, the encapsulation layer 150 may include a first inorganic encapsulation layer 152, an organic encapsulation layer 154, and a second inorganic encapsulation layer 156 which are sequentially stacked, without being limited thereto.

Each of the first inorganic encapsulation layer 152 and the second inorganic encapsulation layer 156 of the encapsulation layer 150 may be made of an inorganic insulating material such as silicon oxide (SiOx) or silicon nitride (SiNx) , without being limited thereto. The organic encapsulation layer 154 of the encapsulation layer 150 may be made of an organic insulating material such as acryl resin, epoxy resin, phenolic resin, polyamide resin, and polyimide resin, without being limited thereto.

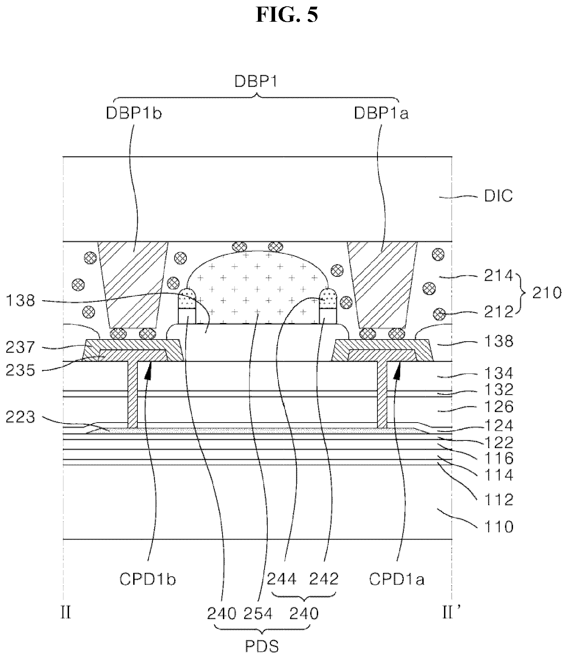

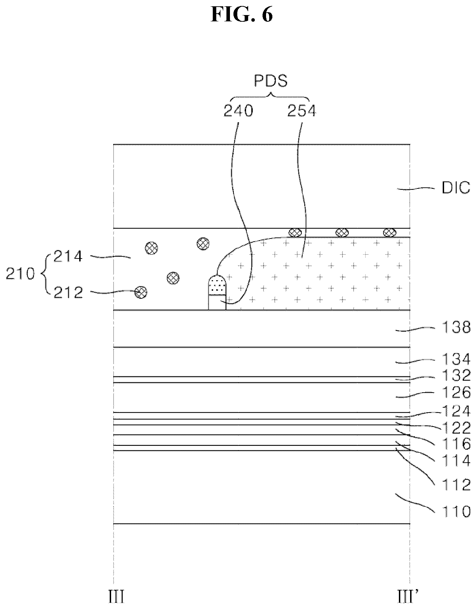

FIG. 5 is a cross-sectional view illustrating a display device taken along a line II-II' of FIG. 3. FIG. 6 is a cross-sectional view illustrating a display device taken along a line III-III' of FIG. 3. A cross-sectional structure of the chip pad area CPA and the pressure distribution structure PDS according to an exemplary embodiment of the present disclosure will be described with reference to FIGS. 5 and 6.

Referring to FIGS. 5 and 6, the chip pads CPD (see FIG. 3) may be disposed on the substrate 110. Although only the first output pad CPD1a and the second output pad CPD1b disposed on the substrate 110 are illustrated in the drawing, the input pad CPD2 (see FIG. 3) may also be disposed on the substrate 110. The driving circuit chip DIC may be mounted on the first and second output pads CPD1a and CPD1b and the input pad CPD2 via an anisotropic conductive film 210. The first output bump DBP1a of the driving circuit chip DIC may be electrically connected to the first output pad CPD1a via conductive particles 212 of the anisotropic conductive film 210. The second output bump DBP1b of the driving circuit chip DIC may be electrically connected to the second output pad CPD1b via the conductive particles 212 of the anisotropic conductive film 210. Although not shown, an input bump of the driving circuit chip DIC may be electrically connected to the input pad CPD2 via the conductive particles 212 of the anisotropic conductive film 210.

The first and second lower buffer layers 112 and 114, the auxiliary buffer layer 116, and the first gate insulating layer 122 may be disposed on the substrate 110. As an example, a pad connection line 223 may be disposed on the first gate insulating layer 122, without being limited thereto. The pad connection line 223 may electrically connect the first output pad CPD1a and the second output pad CPD1b to each other. The pad connection line 223 may be made of the same material as that of the first gate electrode 123, and the pad connection line 223 and the first gate electrode 123 may be formed simultaneously. Embodiments are not limited thereto. As an example, the pad connection line 223 may be disposed on layer different from the first gate insulating layer 122. As an example, the pad connection line 223 may be made of a material different from that of the first gate electrode 123, or the pad connection line 223 and the first gate electrode 123 may be formed separately.

As an example, the first interlayer insulating layer 124, the upper buffer layer 126, the second gate insulating layer 132, and the second interlayer insulating layer 134 may be disposed on the pad connection line 223. Embodiments are not limited thereto. As an example, at least one of the first interlayer insulating layer 124, the upper buffer layer 126, the second gate insulating layer 132, and the second interlayer insulating layer 134 may be omitted depending on the design.

As an example, the first output pad CPD1a, the second output pad CPD1b, and the input pad CPD2 may be disposed on the second interlayer insulating layer 134. As an example, each of the first output pad CPD1a and the second output pad CPD1b may include a lower pad layer 235 and an upper pad layer 237. The input pad (CPD2) may also include a lower pad layer 235 and an upper pad layer 237. The upper pad layer 237 may be directly disposed on the lower pad layer 235. The lower pad layer 235 may be connected to the pad connection line 223 via a through-hole extending through the first interlayer insulating layer 124, the upper buffer layer 126, the second gate insulating layer 132, and the second interlayer insulating layer 134. As an example, the lower pad layer 235 may be made of the same material as that of the first source electrode 125s and the first drain electrode 125d. In this case, the lower pad layer 235, the first source electrode 125s and the first drain electrode 125d may be formed simultaneously. The upper pad layer 237 may be made of the same material as that of the intermediate electrode 137. In this case, the upper pad layer 237 and the intermediate electrode 137 may be formed simultaneously. Embodiments are not limited thereto. As an example, the first output pad CPD1a, the second output pad CPD1b, and the input pad CPD2 may be disposed on a layer other than the second interlayer insulating layer 134. As an example, the first output pad CPD1a, the second output pad CPD1b, and the input pad CPD2 may be disposed on the same layer or different layers. As an example, each of the first output pad CPD1a and the second output pad CPD1b may include one single layer, or two or more layers. As an example, the upper pad layer 237 may overlap the lower pad layer 235. As an example, the upper pad layer 237 may cover both ends of the lower pad layer 235, or may expose one of both ends of the lower pad layer 235. As an example, upper pad layer 237 may expose a portion of the upper surface of the lower pad layer 235. As an example, the lower pad layer 235 and the upper pad layer 237 may be made of a material the same as or different from that of the intermediate electrode 137, the first source electrode 125s and the first drain electrode 125d, without being limited thereto.

The second planarization layer 138 may be disposed on the second interlayer insulating layer 134 so as to cover edges of the plurality of chip pads CPD. The second planarization layer 138 may include a plurality of openings defined therein exposing a partial area (e.g., central area) of each of the plurality of chip pads CPD.

The pressure distribution structure PDS may be disposed on the second planarization layer 138. The pressure distribution structure PDS may be disposed in an area between the first output pad CPD1a and the second output pad CPD1b. Although not shown, the pressure distribution structure PDS may also be disposed in an area between the second output pad CPD1b and the input pad CPD2.

The pressure distribution structure PDS may be disposed between the first output bump DBP1a and the second output bump DBP1b of the driving circuit chip DIC. The pressure distribution structure PDS may also be disposed between the second output bump DBP1b and the input bump of the driving circuit chip DIC. The pressure distribution structure PDS may protrude into a space between the bumps of the driving circuit chip DIC. As an example, an upper surface of the pressure distribution structure PDS may be located closer to an upper surface of each of the bumps of the driving circuit chip DIC than to a lower surface of each of the bumps of the driving circuit chip DIC, without being limited thereto.

The pressure distribution structure PDS may include a buffer portion 254 and an enclosure portion 240 surrounding the buffer portion 254. The enclosure portion 240 may define an area in which the buffer portion 254 is disposed. The enclosure portion 240 may confine the buffer portion 254 so that the buffer portion 254 maintains a predetermined shape. A height or a thickness of the buffer portion 254 may be greater or thicker than a height or a thickness of the enclosure portion 240. The buffer portion 254 may have a convex upper surface. The upper surface of the buffer portion 254 may be located closer to the upper surfaces of the bumps of the driving circuit chip DIC than to the lower surfaces of the bumps of the driving circuit chip DIC.

As an example, the buffer portion 254 may be made of the same material as that of the organic encapsulation layer 154 of the display area AA, without being limited thereto. The enclosure portion 240 may include a lower layer 242 and an upper layer 244 disposed on the lower layer 242. As an example, the lower layer 242 of the enclosure portion 240 may be made of the same material as that of the bank layer 142 of the display area AA, without being limited thereto. As an example, the upper layer 244 of the enclosure portion 240 may be made of the same material as that of the spacer 144 of the display area AA, without being limited thereto. When the bank layer 142 and the spacer 144 of the display area AA are made of the same material and are simultaneously formed in a single process, the lower layer 242 and the upper layer 244 of the enclosure portion 240 may be also made of the same material and are simultaneously formed in a single process, so that the lower layer 242 and the upper layer 244 may not be distinguished from each other.

The anisotropic conductive film 210 disposed between the pressure distribution structure PDS and the driving circuit chip DIC may include an adhesive layer 214 in which the conductive particles 212 are dispersed.

The pressure distribution structure PDS may have a height or thickness similar to a height or thickness of each of the output bumps and the input bumps of the driving circuit chip DIC. The pressure distribution structure PDS may be attached to the driving circuit chip DIC via the anisotropic conductive film 210 disposed between the pressure distribution structure PDS and the driving circuit chip DIC. As an example, some of the conductive particles 212 of the anisotropic conductive film 210 may contact both the upper surface of the pressure distribution structure PDS and the lower surface of the driving circuit chip DIC, without being limited thereto. For example, the pressure distribution structure PDS may be in contact with the lower surface of the driving circuit chip DIC. As an example, a distance between the upper surface of the pressure distribution structure PDS and the lower surface of the driving circuit chip DIC may be equal to or smaller than a diameter of some of the conductive particles 212, without being limited thereto.

According to an exemplary embodiment of the present disclosure, the pressure distribution structure PDS may be disposed around the chip pads CPD of the display panel DP. Thus, the driving circuit chip DIC may be supported by the pressure distribution structure PDS when the driving circuit chip DIC is mounted on the display panel DP. Thus, the pressure applied to the chip pads CPD of the display panel DP and the lines around the chip pads can be distributed when the driving circuit chip DIC is mounted thereon.

According to an exemplary embodiment of the present disclosure, since the pressure distribution structure PDS is made of an organic insulating material, an impact applied to the chip pads CPD of the display panel DP and the lines around the chip pads when the driving circuit chip DIC is mounted on the display panel can be efficiently absorbed by the pressure distribution structure PDS.

According to an exemplary embodiment of the present disclosure, as the pressure applied to the chip pads CPD of the display panel DP is distributed and the impact is absorbed by the pressure distribution structure PDS when the driving circuit chip DIC is mounted on the display panel DP, cracks can be reduced or prevented from occurring in the chip pads CPD of the display panel DP disposed under the driving circuit chip DIC and the lines around the chip pads.

According to an exemplary embodiment of the present disclosure, the pressure distribution structure PDS is configured to include the buffer portion 254 and the enclosure portion 240 surrounding a side edge of the buffer portion 254, the height or thickness of the pressure distribution structure PDS can be easily adjusted by adjusting the height or thickness of the buffer portion 254. Accordingly, the pressure distribution structure PDS can be formed to have the height or thickness similar to the height or thickness of each of the bumps of the driving circuit chip DIC so that the pressure distribution structure PDS can support the lower surface of the driving circuit chip DIC in the mounting process of the driving circuit chip DIC.

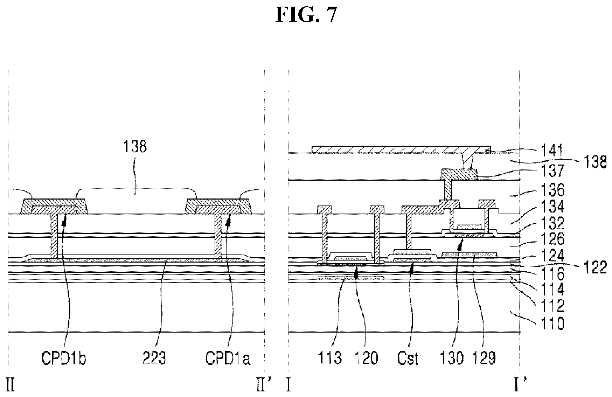

FIGS. 7 to 9 are cross-sectional views illustrating a method for manufacturing a pressure distribution structure according to an exemplary embodiment of the present disclosure.

Referring to FIG. 7, the first light-shielding layer 113, the first thin-film transistor 120, the capacitor Cst, the second light-shielding layer 129, the second thin-film transistor 130, the intermediate electrode 137, and the anode electrode 141 may be formed on the substrate 110 in the display area AA. As described with reference to FIG. 4, various insulating layers required for the process of forming the above-described components may also be formed. The anode electrode 141 may be disposed on the second planarization layer 138, and may be connected to the intermediate electrode 137 disposed on the first planarization layer 136 via a through-hole extending through the second planarization layer 138.

The pad connection line 223 and the chip pads CPD including the first and second output pads CPD1a and CPD1b may be formed on the substrate 110 in the chip pad area CPA of the non-display area NAA. As described with reference to FIGS. 5 and 6, various insulating layers required for the process of forming the above-described components may also be formed. The second planarization layer 138 may be disposed on the second interlayer insulating layer 134 so as to cover the edges of the chip pads CPD including the first and second output pads CPD1a and CPD1b.

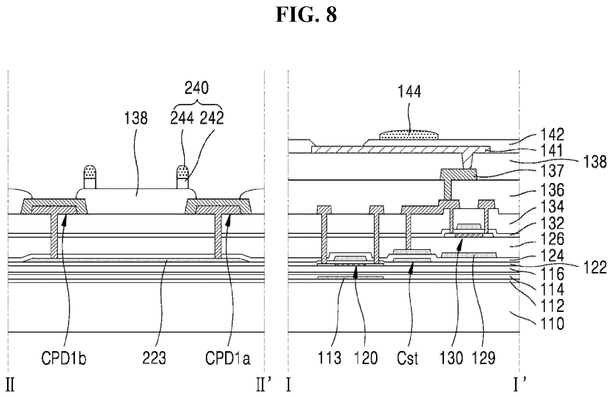

Referring to FIG. 8, the bank layer 142 and the spacer 144 may be formed in the display area AA, and the enclosure portion 240 including the lower layer 242 and the upper layer 244 may be formed in the chip pad area CPA of the non-display area NAA. The lower layer 242 of the enclosure portion 240 may be made of the same material as that of the bank layer 142 of the display area AA and may be formed in the same process as a process in which the bank layer 142 of the display area AA is formed, without being limited thereto. The upper layer 244 of the enclosure portion 240 may be made of the same material as that of the spacer 144 of the display area AA and may be formed in the same process as a process in which the spacer 144 of the display area AA is formed, without being limited thereto. When the bank layer 142 and the spacer 144 of the display area AA are made of the same material and are simultaneously formed in a single process, the lower layer 242 and the upper layer 244 of the enclosure portion 240 may also be made of the same material and may be simultaneously formed in a single process, without being limited thereto.

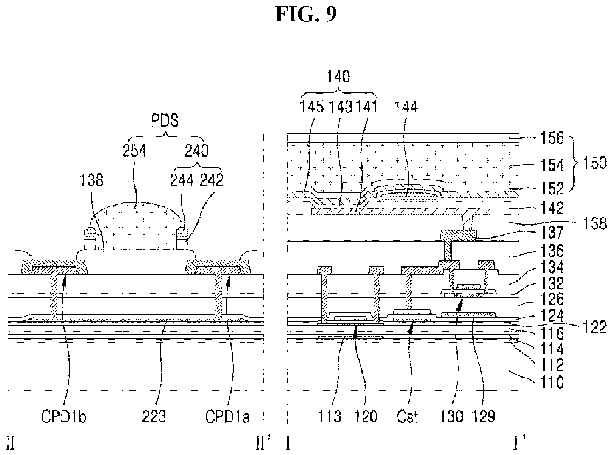

Referring to FIG. 9, the light-emitting layer 143, the cathode electrode 145, the first inorganic encapsulation layer 152, the organic encapsulation layer 154, and the second inorganic encapsulation layer 156 may be formed in the display area AA. The buffer portion 254 may be formed in an area defined by the enclosure portion 240 in the chip pad area CPA of the non-display area NAA. As an example, the buffer portion 254 may be made of the same organic insulating material as that of the organic encapsulation layer 154, without being limited thereto. Alternatively, as an example, the buffer portion 254 and the organic encapsulation layer 154 may not be formed simultaneously, but may be formed in separate processes. The buffer portion 254 may be formed in, for example, an inkjet process.

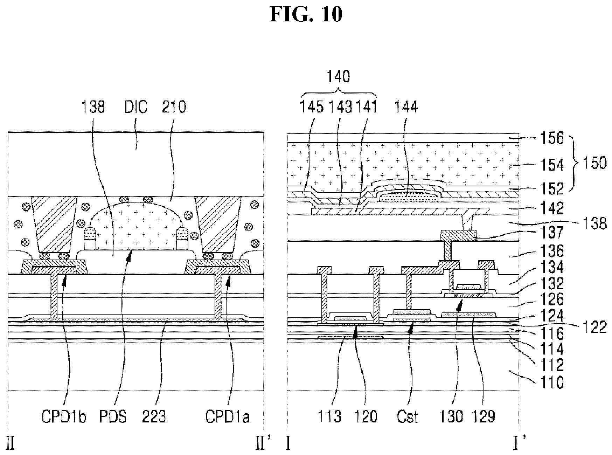

Referring to FIG. 10, the driving circuit chip DIC may be mounted on the chip pad area CPA of the non-display area NAA via the anisotropic conductive film 210. After the anisotropic conductive film 210 and the driving circuit chip DIC have been positioned on the chip pad area CPA, the driving circuit chip DIC is pressed with a predetermined pressure to bond the bumps of the driving circuit chip DIC to the pads of the chip pad area CPA. In this case, the pressure distribution structure PDS may support the lower surface of the driving circuit chip DIC via the anisotropic conductive film 210 and may distribute the pressure applied to the chip pad area CPA via the bumps of the driving circuit chip DIC.

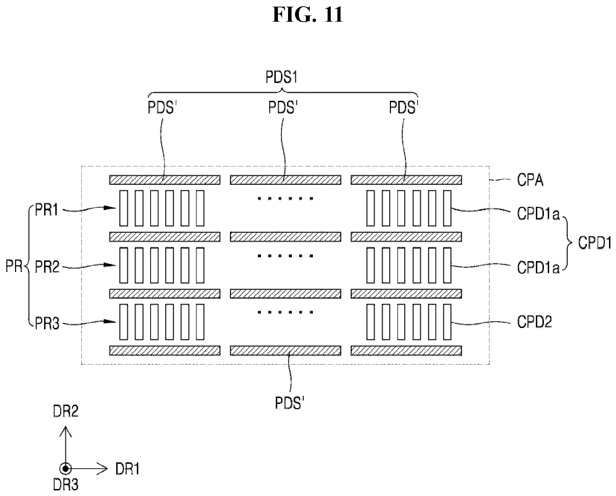

FIGS. 11 to 14 are plan views illustrating pressure distribution structures according to exemplary embodiments of the present disclosure.

Referring to FIG. 11, at least one pressure distribution structure PDS1 among the plurality of pressure distribution structures PDS1 may be divided into a plurality of pressure distribution patterns PDS' spaced apart from each other in the first direction DR1. As illustrated in FIG. 11, each of all of the pressure distribution structures PDS1 may be divided into a plurality of pressure distribution patterns PDS'. In an exemplary embodiment, each of some of the pressure distribution structures PDS1 may be divided into a plurality of pressure distribution patterns PDS' spaced apart from each other in the first direction DR1. FIG. 11 illustrates an example in which one pressure distribution structure PDS1 is divided into three pressure distribution patterns PDS'. However, the present disclosure is not limited thereto.

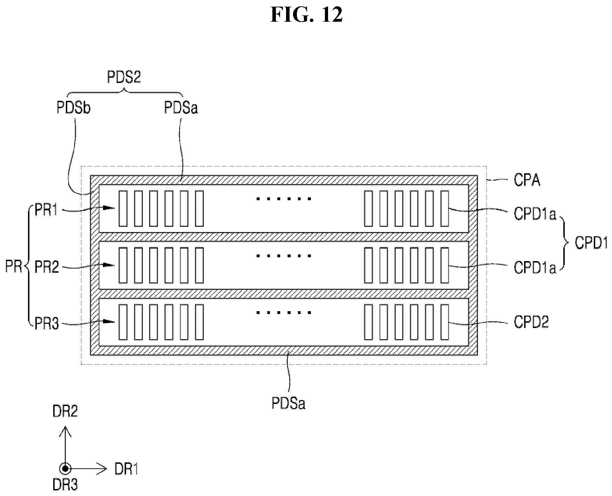

Referring to FIG. 12, in a plan view of the display panel, each of a plurality of first pressure distribution structures PDSa may be disposed on each of upper and lower sides of each of the plurality of pad rows PR, and two second pressure distribution structures PDSb may be disposed on left and right sides of each of the plurality of pad rows PR. As an example, the two second pressure distribution structures PDSb may be connected respectively to ends of the plurality of first pressure distribution structures PDSa, or may be separated from the plurality of first pressure distribution structures PDSa. The upper and lower sides of each of the plurality of pad rows PR may be opposite sides in the second direction DR2 of each of the plurality of pad rows PR. The left and right sides of each of the plurality of pad rows PR may be opposite sides in the first direction DR1 of each of the plurality of pad rows PR. The plurality of first pressure distribution structures PDSa may extend in the first direction DR1 and the second pressure distribution structures PDSb may extend in the second direction DR2. As an example, the plurality of first pressure distribution structures PDSa and the two second pressure distribution structures PDSb may be integrally formed to constitute one pressure distribution structure PDS2, or may be separately formed to constitute separate parts.

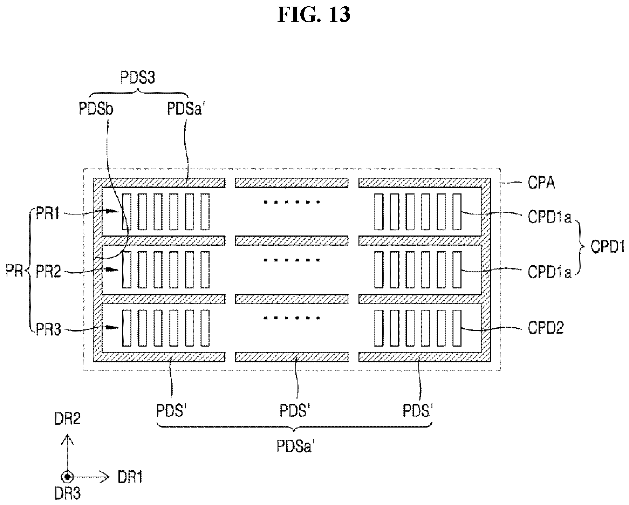

Referring to FIG. 13, in a plan view of the display panel, each of a plurality of first pressure distribution structures PDSa' may be disposed on each of upper and lower sides of each of the plurality of pad rows PR, and two second pressure distribution structures PDSb may be disposed on left and right sides of each of the plurality of pad rows PR and connected respectively to ends of the plurality of first pressure distribution structures PDSa'. At least one of the plurality of first pressure distribution structures PDSa' may be divided into a plurality of first pressure distribution patterns PDS' spaced apart from each other in the first direction DR1. As illustrated in FIG. 13, each of all of the first pressure distribution structures PDSa' may be divided into a plurality of pressure distribution patterns PDS'. In an exemplary embodiment, each of some of the plurality of pressure distribution structures PDSa' may be divided into a plurality of pressure distribution patterns PDS' spaced apart from each other in the first direction DR1. The second pressure distribution structures PDSb may be respectively connected to ends of the outermost first pressure distribution patterns PDS' among the plurality of first pressure distribution patterns PDS'.

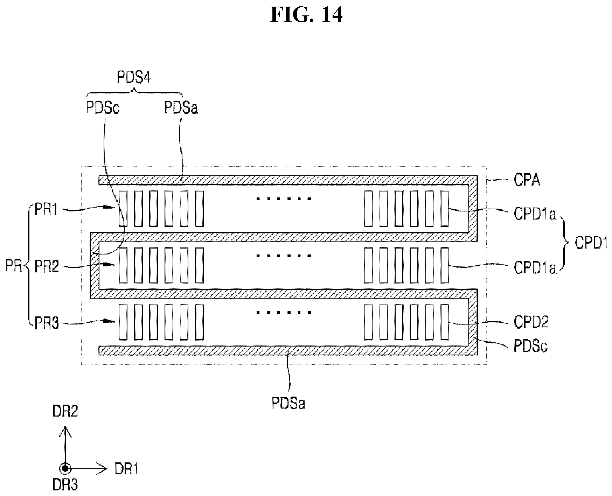

Referring to FIG. 14, in a plan view of the display panel, each of a plurality of first pressure distribution structures PDSa may be disposed on each of upper and lower sides of each of the plurality of pad rows PR. Each of a plurality of second pressure distribution structures PDSc may be connected to ends of two first pressure distribution structures PDSa adjacent to each other in the second direction DR2. The plurality of second pressure distribution structures PDSc may be arranged alternately on the left side or right side of different pad rows in the plan view of the display panel. As an example, the plurality of second pressure dissipating structures PDSc may be placed on the right side of each of odd-numbered pad rows and on the left side of each of even-numbered pad rows in the plan view of the display panel, without being limited thereto. As an example, the plurality of first pressure distribution structures PDSa and the plurality of second pressure distribution structures PDSc may be integrally formed to constitute one pressure distribution structure PDS4 extending in a continuous manner, without being limited thereto. In an exemplary embodiment, two second pressure distribution structures PDSc may be respectively disposed on both left and right sides of each of the two odd-numbered pad rows. In this case, a plurality of ring-shaped pressure distribution structures may be formed.

Although it is illustrated and described that the pressure distribution structure PDS are arranged in the first direction DR1 or the second direction DR2, embodiments are not limited thereto. As an example, the pressure distribution structure PDS may be arranged in a direction other than the first direction DR1 or the second direction DR2.

The display devices according to various exemplary aspects and exemplary embodiments of the present disclosure may be described as follows.

A first exemplary aspect of the present disclosure provides a display device comprising: a substrate including a display area and a non-display area around the display area; a chip pad area disposed on the non-display area of the substrate, wherein a plurality of chip pads are disposed in the chip pad area and are arranged in a plurality of rows to constitute a plurality of pad rows; a driving circuit chip mounted on the chip pad area; and at least one pressure distribution structure vertically overlapping the driving circuit chip and disposed adjacent to at least one of the plurality of pad rows.

In accordance with some exemplary embodiments of the first aspect of the present disclosure, each of the pad rows includes a plurality of chip pads arranged in a first direction, wherein the at least one pressure distribution structure extends in the first direction.

In accordance with some exemplary embodiments of the first aspect of the present disclosure, the at least one pressure distribution structure is disposed on a planarization layer covering edges of the plurality of chip pads, and is adhered to the driving circuit chip via an anisotropic conductive film.

In accordance with some exemplary embodiments of the first aspect of the present disclosure, one or more of conductive particles of the anisotropic conductive film contact both an upper surface of the at least one pressure distribution structure and a lower surface of the driving circuit chip.

In accordance with some exemplary embodiments of the first aspect of the present disclosure, the at least one pressure distribution structure protrudes into a space between bumps of the driving circuit chip.

In accordance with some exemplary embodiments of the first aspect of the present disclosure, the at least one pressure distribution structure is divided into a plurality of pressure distribution patterns spaced apart from each other.

In accordance with some exemplary embodiments of the first aspect of the present disclosure, the at least one pressure distribution structure includes: a plurality of first pressure distribution structures respectively disposed on upper and lower sides of each of the plurality of pad rows in a plan view of the display device, and at least one second pressure distribution structure disposed on at least one of left side and right side of at least one of the plurality of pad rows and connected to one end of ends of the plurality of first pressure distribution structures in the plan view of the display device.

In accordance with some exemplary embodiments of the first aspect of the present disclosure, each of the at least one pressure distribution structure includes a buffer portion and an enclosure portion surrounding the buffer portion.

In accordance with some exemplary embodiments of the first aspect of the present disclosure, a height of the buffer portion is greater than a height of the enclosure portion.

In accordance with some exemplary embodiments of the first aspect of the present disclosure, the buffer portion has a convex upper surface.

In accordance with some exemplary embodiments of the first aspect of the present disclosure, the buffer portion is made of the same material as a material of an organic encapsulation layer disposed on the display area.

In accordance with some exemplary embodiments of the first aspect of the present disclosure, the enclosure portion includes a lower layer and an upper layer disposed on the lower layer, wherein the lower layer of the enclosure portion is made of the same material as a material of a bank layer disposed on the display area, wherein the upper layer of the enclosure portion is made of the same material as a material of a spacer disposed on the display area.

A second exemplary aspect of the present disclosure provides a display device comprising: a substrate including a display area and a non-display area around the display area; a chip pad area disposed on the non-display area of the substrate and including a plurality of pads; a planarization layer covering edges of the plurality of pads and disposed on the substrate; a driving circuit chip mounted on the chip pad area via an anisotropic conductive film; and at least one pressure distribution structure disposed between the planarization layer and the driving circuit chip, wherein the at least one pressure distribution structure is disposed between bumps of the driving circuit chip, wherein an upper surface of the at least one pressure distribution structure is disposed closer to an upper surface of each of the bumps of the driving circuit chip than to a lower surface of each of the bumps of the driving circuit chip.

In accordance with some exemplary embodiments of the second aspect of the present disclosure, one or more conductive particles of the anisotropic conductive film contact both an upper surface of the at least one pressure distribution structure and a lower surface of the driving circuit chip.

In accordance with some exemplary embodiments of the second aspect of the present disclosure, each of the at least one pressure distribution structure includes a buffer portion and an enclosure portion surrounding the buffer portion.

In accordance with some exemplary embodiments of the second aspect of the present disclosure, each of the buffer portion and the enclosure portion is made of an organic insulating material.

In accordance with some exemplary embodiments of the second aspect of the present disclosure, a height of the buffer portion is greater than a height of the enclosure portion, wherein the buffer portion has a convex upper surface.

In accordance with some exemplary embodiments of the second aspect of the present disclosure, the plurality of pads are arranged in a plurality of rows to constitute a plurality of pad rows in a plan view of the display device, wherein the at least one pressure distribution structure is disposed adjacent to one or more of the plurality of pad rows.

In accordance with some exemplary embodiments of the second aspect of the present disclosure, each of the pad rows includes a plurality of chip pads arranged in a first direction, wherein the at least one pressure distribution structure extends in the first direction.

In accordance with some exemplary embodiments of the second aspect of the present disclosure, the at least one pressure distribution structure is divided into a plurality of pressure distribution patterns spaced apart from each other in a first direction.

In accordance with some exemplary embodiments of the second aspect of the present disclosure, the at least one pressure distribution structure includes: a plurality of first pressure distribution structures respectively disposed on upper and lower sides of each of the plurality of pad rows in a plan view of the display device, and at least one second pressure distribution structure disposed on at least one of left side and right side of each of the plurality of pad rows and connected to one end of ends of the plurality of first pressure distribution structures in the plan view of the display device.

Although some embodiments of the present disclosure have been described above with reference to the accompanying drawings, the present disclosure may not be limited to some embodiments and may be implemented in various different forms. Those of ordinary skill in the technical field to which the present disclosure belongs will be able to appreciate that the present disclosure may be implemented in other specific forms without changing the technical idea or essential features of the present disclosure. Therefore, it should be understood that some embodiments as described above are not restrictive but illustrative in all respects.

The disclosure comprises the following items:
1. A display device comprising:
   a substrate including a display area and a non-display area around the display area;
   a chip pad area disposed on the non-display area of the substrate, wherein a plurality of chip pads are disposed in the chip pad area;
   a driving circuit chip mounted on the chip pad area; and
   at least one pressure distribution structure vertically overlapping the driving circuit chip and disposed adjacent to at least one of the plurality of chip pads.
2. The display device of item 1, wherein the plurality of chip pads are arranged in a plurality of rows to constitute a plurality of pad rows.
3. The display device of item 1 or item 2. wherein each of the pad rows includes a plurality of chip pads arranged in a first direction,
   wherein the at least one pressure distribution structure extends in the first direction. wherein the chip pad area is located spaced apart from one side of the display area in a second direction intersecting the first direction.
4. The display device of any preceding item, wherein the at least one pressure distribution structure is disposed on a planarization layer covering edges of the plurality of chip pads, and is adhered to the driving circuit chip via an anisotropic conductive film.
5. The display device of any preceding item, wherein one or more of conductive particles of the anisotropic conductive film contact both an upper surface of the at least one pressure distribution structure and a lower surface of the driving circuit chip.
6. The display device of any preceding item, wherein the at least one pressure distribution structure protrudes into a space between bumps of the driving circuit chip.
7. The display device of any preceding item, wherein the at least one pressure distribution structure is divided into a plurality of pressure distribution patterns spaced apart from each other.
8. The display device of any preceding item, wherein the at least one pressure distribution structure is disposed adjacent to one or more the plurality of pad rows.
9. The display device of any preceding item, wherein the at least one pressure distribution structure includes:
   a plurality of first pressure distribution structures respectively disposed on upper and lower sides of at least one of the plurality of pad rows in a plan view of the display device; and
   at least one second pressure distribution structure disposed on at least one of left side and right side of the at least one of the plurality of pad rows.
10. The display device of any preceding item, wherein the at least one second pressure distribution structure is connected to one end of ends of the plurality of first pressure distribution structures in the plan view of the display device.
11. The display device of any preceding item, wherein each of the at least one pressure distribution structure includes a buffer portion and an enclosure portion surrounding the buffer portion.
12. The display device of any preceding item, wherein a height of the buffer portion is higher than a height of the enclosure portion.
13. The display device of any preceding item, wherein the buffer portion has a convex upper surface.
14. The display device of any preceding item, wherein the buffer portion is made of a same material as a material of an organic encapsulation layer disposed on the display area.
15. The display device of any preceding item, wherein the enclosure portion includes a lower layer and an upper layer disposed on the lower layer,
   wherein the lower layer of the enclosure portion is made of a same material as a material of a bank layer disposed on the display area,
   wherein the upper layer of the enclosure portion is made of a same material as a material of a spacer disposed on the display area.
16. A display device comprising:
   a substrate including a display area and a non-display area around the display area;
   a chip pad area disposed on the non-display area of the substrate and including a plurality of pads;
   a planarization layer covering edges of the plurality of pads and disposed on the substrate;
   a driving circuit chip mounted on the chip pad area via an anisotropic conductive film; and
   at least one pressure distribution structure disposed between the planarization layer and the driving circuit chip,
   wherein the at least one pressure distribution structure is disposed between bumps of the driving circuit chip,
   wherein an upper surface of the at least one pressure distribution structure is disposed closer to an upper surface of each of the bumps of the driving circuit chip than to a lower surface of each of the bumps of the driving circuit chip.
17. The display device of item 16, wherein one or more of conductive particles of the anisotropic conductive film contact both an upper surface of the at least one pressure distribution structure and a lower surface of the driving circuit chip.
18. The display device of item 16 or item 17, wherein each of the at least one pressure distribution structure includes a buffer portion and an enclosure portion surrounding the buffer portion,
   wherein each of the buffer portion and the enclosure portion is made of an organic insulating material.
19. The display device of any of items 16-18, wherein a height of the buffer portion is higher than a height of the enclosure portion, and
   wherein the buffer portion has a convex upper surface.
20. The display device of any of items 16-19, wherein the plurality of pads are arranged in a plurality of rows to constitute a plurality of pad rows in a plan view of the display device,
   wherein the at least one pressure distribution structure is disposed adjacent to one or more of the plurality of pad rows.

## Claims

1. A display device comprising:
a substrate including a display area and a non-display area around the display area;
a chip pad area disposed on the non-display area of the substrate, wherein a plurality of chip pads are disposed in the chip pad area;
a driving circuit chip mounted on the chip pad area; and
at least one pressure distribution structure vertically overlapping the driving circuit chip and disposed adjacent to at least one of the plurality of chip pads.

2. The display device of claim 1, wherein the plurality of chip pads are arranged in a plurality of rows to constitute a plurality of pad rows.

3. The display device of claim 2, wherein each of the pad rows includes a plurality of chip pads arranged in a first direction,
wherein the at least one pressure distribution structure extends in the first direction. wherein the chip pad area is located spaced apart from one side of the display area in a second direction intersecting the first direction.

4. The display device of any preceding claim, wherein the at least one pressure distribution structure is disposed on a planarization layer covering edges of the plurality of chip pads, and is adhered to the driving circuit chip via an anisotropic conductive film.

5. The display device of claim 4, wherein one or more of conductive particles of the anisotropic conductive film contact both an upper surface of the at least one pressure distribution structure and a lower surface of the driving circuit chip.

6. The display device of any preceding claim, wherein the at least one pressure distribution structure protrudes into a space between bumps of the driving circuit chip.

7. The display device of any preceding claim, wherein the at least one pressure distribution structure is divided into a plurality of pressure distribution patterns spaced apart from each other.

8. The display device of claim 2 or claim 3, wherein the at least one pressure distribution structure is disposed adjacent to one or more the plurality of pad rows.

9. The display device of claim 8, wherein the at least one pressure distribution structure includes:
a plurality of first pressure distribution structures respectively disposed on upper and lower sides of at least one of the plurality of pad rows in a plan view of the display device; and
at least one second pressure distribution structure disposed on at least one of left side and right side of the at least one of the plurality of pad rows.

10. The display device of claim 9, wherein the at least one second pressure distribution structure is connected to one end of ends of the plurality of first pressure distribution structures in the plan view of the display device.

11. The display device of any preceding claim, wherein each of the at least one pressure distribution structure includes a buffer portion and an enclosure portion surrounding the buffer portion.

12. The display device of claim 11, wherein a height of the buffer portion is higher than a height of the enclosure portion.

13. The display device of claim 11 or claim 12, wherein the buffer portion has a convex upper surface.

14. The display device of any of claims 11-13, wherein the buffer portion is made of a same material as a material of an organic encapsulation layer disposed on the display area.

15. The display device of any of claims 11-14, wherein the enclosure portion includes a lower layer and an upper layer disposed on the lower layer,
wherein the lower layer of the enclosure portion is made of a same material as a material of a bank layer disposed on the display area,
wherein the upper layer of the enclosure portion is made of a same material as a material of a spacer disposed on the display area.
